# EUROPEAN PATENT APPLICATION

(11) **EP 2 045 845 A2**
(43) Date of publication of application: **08.04.2009**
(21) Application number: 08162993.3
(22) Date of filing: 26.08.2008
(51) Int. Cl.: H01L 33/00

(54) **III-nitride semiconductor light emitting device**

(30) Priority: 02.10.2007 KR 20070099397
(71) Applicant: Epivalley Co., Ltd., Gumi-city, Gyungbuk 730-030 (KR)
(72) Inventor: Park, Eun Hyun, Bundang-gu, Seongnam-si Gyeonggi-Do 463-070 (KR); Jeon, Soo Kun, Buindang-gu, Seongnam-si, Gyeonggi-Do 463-740 (KR); Lim, Jae Gu, Bundang-gu, Seongnam-si, Gyeonggi-Do 463-500 (KR)
(74) Representative: Schmitt, Armand

(57) **Abstract**

The present invention relates to a III-nitride semiconductor light emitting device, and more particularly, to a III-nitride semiconductor light emitting device which can facilitate current spreading and improve electrostatic discharge characteristic by providing an undoped GaN layer (30b) with a thickness over 100 A in an n-side contact layer (30).

## Description

### [Technical Field]

The present invention relates to a III-nitride semiconductor light emitting device, and more particularly, to a III-nitride semiconductor light emitting device which can facilitate current spreading and improve electrostatic discharge characteristic by providing an undoped GaN layer with a thickness over 100 A in an n-side contact layer.

The III-nitride semiconductor light emitting device means a light emitting device such as a light emitting diode including a compound semiconductor layer composed of Al₍ₓ₎Ga_{(y)}In_{(1-x-y)}N (0≤x≤1, 0≤y≤1, 0≤x+y≤1), and may further include a material composed of other group elements, such as SiC, SiN, SiCN and CN, and a semiconductor layer made of such materials.

### [Background Art]

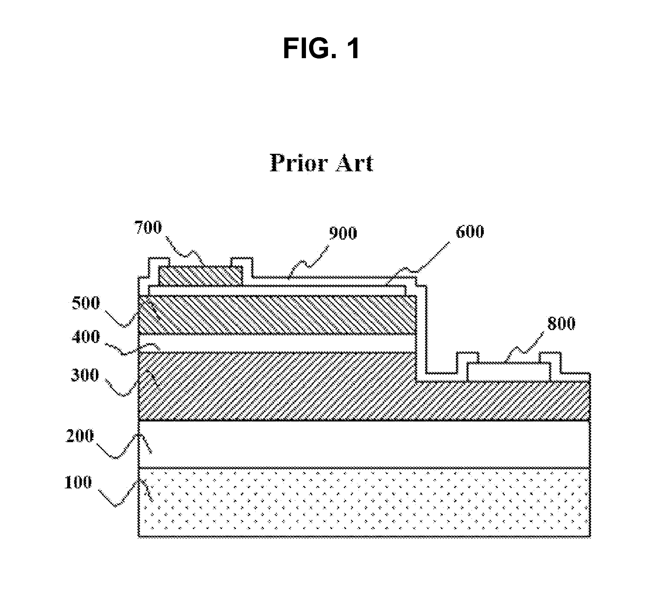

FIG. 1 is a view illustrating one example of a conventional III-nitride semiconductor light emitting device. The III-nitride semiconductor light emitting device includes a substrate 100, a buffer layer 200 epitaxially grown on the substrate 100, an n-type nitride semiconductor layer 300 epitaxially grown on the buffer layer 200, an active layer 400 epitaxially grown on the n-type nitride semiconductor layer 300, a p-type nitride semiconductor layer 500 epitaxially grown on the active layer 400, a p-side electrode 600 formed on the p-type nitride semiconductor layer 500, a p-side bonding pad 700 formed on the p-side electrode 600, an n-side electrode 800 formed on the n-type nitride semiconductor layer exposed by mesa-etching the p-type nitride semiconductor layer 500 and the active layer 400, and a protective film 900.

In the case of the substrate 100, a GaN substrate can be used as a homo-substrate, and a sapphire substrate, a SiC substrate or a Si substrate can be used as a hetero-substrate. However, any type of substrate that can grow a nitride semiconductor layer thereon can be employed. In the case that the SiC substrate is used, the n-side electrode 800 can be formed on the side of the SiC substrate.

The nitride semiconductor layers epitaxially grown on the substrate 100 are grown usually by metal organic chemical vapor deposition (MOCVD).

The buffer layer 200 serves to overcome differences in lattice constant and thermal expansion coefficient between the hetero-substrate 100 and the nitride semiconductor layers. U.S. Pat. No. 5,122,845 discloses a technique of growing an AlN buffer layer with a thickness of 100 to 500 Å on a sapphire substrate at 380 to 800 °C. In addition, U.S. Pat. No. 5,290,393 discloses a technique of growing an Al₍ₓ₎Ga₍₁₋ₓ₎N (0≤x<1) buffer layer with a thickness of 10 to 5000 Å on a sapphire substrate at 200 to 900 °C. Moreover, PCT Publication No. WO/05/053042 discloses a technique of growing a SiC buffer layer (seed layer) at 600 to 990 °C, and growing an In₍ₓ₎Ga₍₁₋ₓ₎N (0<x≤1) thereon. Preferably, it is provided with an undoped GaN layer with a thickness of 1 to several µm on the AlN buffer layer, Al₍ₓ₎Ga₍₁₋ₓ₎N (0≤x<1) buffer layer or SiC/In₍ₓ₎Ga₍₁₋ₓ₎N (0<x≤1) layer.

In the n-type nitride semiconductor layer 300, at least the n-side electrode 800 formed region (n-type contact layer) is doped with a dopant. Preferably, the n-type contact layer is made of GaN and doped with Si. U.S. Pat. No. 5,733,796 discloses a technique of doping an n-type contact layer at a target doping concentration by adjusting the mixture ratio of Si and other source materials.

The active layer 400 generates light quanta (light) by recombination of electrons and holes. Normally, the active layer 400 contains In₍ₓ₎Ga₍₁₋ₓ₎N (0<x≤1) and has single or multi-quantum well layers. PCT Publication No. WO/02/021121 discloses a technique of doping some portions of a plurality of quantum well layers and barrier layers.

The p-type nitride semiconductor layer 500 is doped with an appropriate dopant such as Mg, and has p-type conductivity by an activation process. U.S. Pat. No. 5,247,533 discloses a technique of activating a p-type nitride semiconductor layer by electron beam irradiation. Moreover, U.S. Pat. No. 5,306,662 discloses a technique of activating a p-type nitride semiconductor layer by annealing over 400 °C. PCT Publication No. WO/05/022655 discloses a technique of endowing a p-type nitride semiconductor layer with p-type conductivity without an activation process, by using ammonia and a hydrazine-based source material together as a nitrogen precursor for growing the p-type nitride semiconductor layer.

The p-side electrode 600 is provided to facilitate current supply to the p-type nitride semiconductor layer 500. U.S. Pat. No. 5,563,422 discloses a technique associated with a light transmitting electrode composed of Ni and Au and formed almost on the entire surface of the p-type nitride semiconductor layer 500 and in ohmic-contact with the p-type nitride semiconductor layer 500. In addition, U.S. Pat. No. 6,515,306 discloses a technique of forming an n-type superlattice layer on a p-type nitride semiconductor layer, and forming a light transmitting electrode made of ITO thereon.

Meanwhile, the light transmitting electrode 600 can be formed thick not to transmit but to reflect light toward the substrate 100. This technique is called a flip chip technique. U.S. Pat. No. 6,194,743 discloses a technique associated with an electrode structure including an Ag layer with a thickness over 20 nm, a diffusion barrier layer covering the Ag layer, and a bonding layer containing Au and Al, and covering the diffusion barrier layer.

The p-side bonding pad 700 and the n-side electrode 800 are provided for current supply and external wire bonding. U.S. Pat. No. 5,563,422 discloses a technique of forming an n-side electrode with Ti and Al.

The protection film 900 can be made of SiO₂, and may be omitted.

In the meantime, the n-type nitride semiconductor layer 300 or the p-type nitride semiconductor layer 500 can be constructed as single or plural layers.

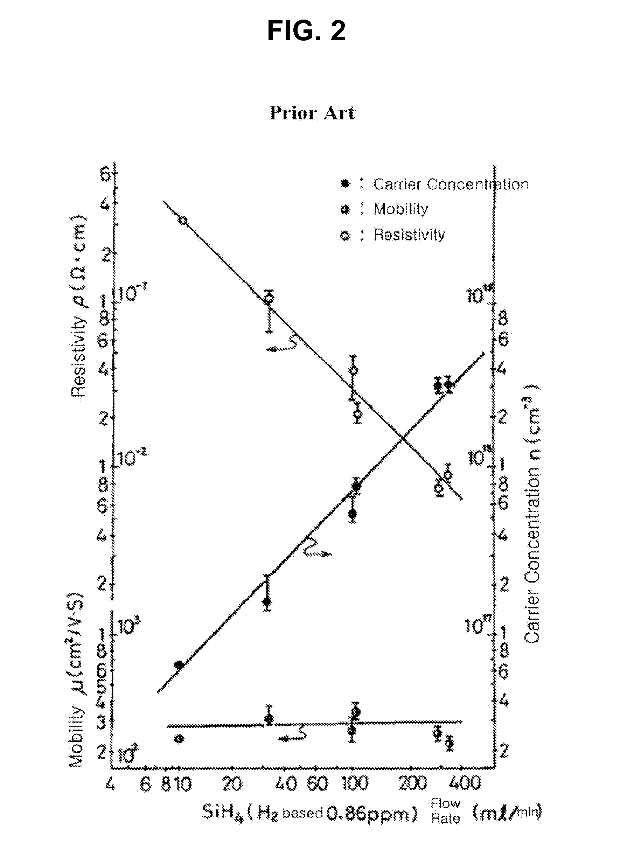

FIG. 2 is an explanatory view illustrating a doping method of an n-type nitride semiconductor layer disclosed in US Patent 5,733,796, particularly, a technology of controlling an n-type nitride semiconductor layer at a target doping concentration by adjusting a mixture ratio of Si source and other source materials within a range (∼3 × 10¹⁸/cm³) where an input amount of Si source and a carrier concentration (or resistivity) are linearly proportional. It is pointed out that crystallinity of the nitride semiconductor layer is made seriously degraded, when the doping is performed at a concentration of about 1 × 10¹⁹/cm³_{.}

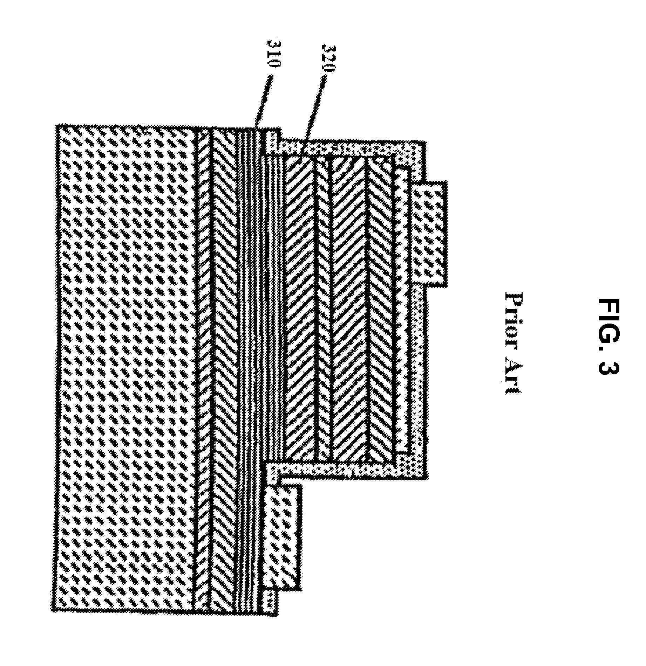

FIG. 3 is an explanatory view illustrating a doping method of an n-type nitride semiconductor layer disclosed in PCT Publication No. WO/99/005728, particularly, a technology of forming an n-type nitride semiconductor layer 310 having a superlattice structure as an n-side contact layer to design around the technology of FIG. 2. In detail, the n-side contact layer 310 is formed by repeatedly stacking an n-type GaN layer with a thickness of 20 A doped at a concentration of 1 × 10¹⁹/cm³ and an undoped GaN layer with a thickness of 20 A at periods of 250. Here, the superlattice structure indicates a structure where layers with a thickness not greater than 100 A are repeatedly stacked. A composition, doping concentration and/or thickness thereof may be different.

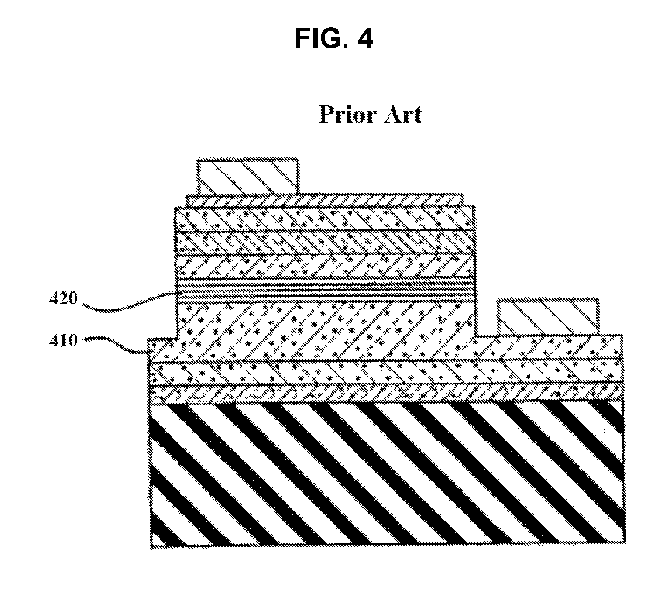

FIG. 4 is an explanatory view illustrating a doping method of an n-type nitride semiconductor layer disclosed in PCT Publication No. WO/99/046822, particularly, a technology of forming an n-side contact layer 410 with a thickness of 3 µm at a doping concentration of 3 × 10¹⁹/cm³, and forming thereon an n-type nitride semiconductor layer 420 having a superlattice structure or multilayered structure with a different composition, doping concentration and/or thickness so as to recover low crystallinity of the n-side contact layer 410. The n-type nitride semiconductor layer 420 having the superlattice structure or multilayered structure is doped at a concentration not greater than 1 × 10¹⁹/cm³.

Meanwhile, an undoped GaN layer (hereinafter, referred to as 'un-GaN layer') is used to improve electrostatic discharge (ESD) characteristic. The light emitting device of FIG. 3 uses an un-GaN layer 320 with a thickness of 100 A, and the light emitting device of FIG. 4 uses an un-GaN layer 431 with a thickness of 2000 A, an n-type GaN layer 432 with a thickness of 300 A doped at a concentration of 4.5 × 10¹⁸/cm³, and an un-GaN layer 433 with a thickness of 50 A as shown in FIG. 5.

However, in the prior art, an un-GaN layer with a thickness over 100 A cannot be used in the n-side contact layer 310 and 410 to dope the n-type nitride semiconductor layer or improve ESD characteristic. The n-side contact layer 310 and 410 is mesa-etched to form an n-side electrode 340 and 440 thereon, so there is a disadvantage of raising a forward voltage when the n-side electrode 340 and 440 is formed on the un-GaN layer. In addition, the n-side contact layer 310 and 410 must be formed over a predetermined thickness, e.g., 1 µm to form the n-side electrode 340 and 440 and spread current well, so there is also a disadvantage of raising a forward voltage when a plurality of un-GaN layers are positioned in the n-side contact layer 310 and 410.

Moreover, in a case where the p-side bonding pad 700 and the n-side electrode 800 are positioned to be spaced apart on one side of the light emitting device as shown in FIG. 1, a current bottleneck phenomenon of electrons introduced from the n-side electrode 800 may occur unlike a vertical light emitting device. This phenomenon can be a serious problem in a large-sized light emitting device. If static electricity is generated, electrostatic current may be concentrated to destroy the light emitting device. Accordingly, it is necessary for the n-side contact layer to have a high doping concentration and a large thickness. If the n-side contact layer has a high doping concentration and a large thickness, a strong strain is applied to the nitride semiconductor layer during the growth. Thus, the nitride semiconductor layer is grown in a direction of relieving the strain, which degrades crystallinity. In this viewpoint (of maintaining a high concentration and obtaining good crystallinity), US Patent 5,733,796 points out that crystallinity is degraded at a doping concentration over 1 × 10¹⁹/cm³. In PCT Publication No. WO/99/005728, a technology is suggested to bypass the technology in US Patent 5,733,796 by using the n-side contact layer 310 having the superlattice structure where a thin n-type GaN layer with a thickness of 20 A doped at a concentration of 1 × 10¹⁹/cm³ and a thin un-GaN layer with a thickness of 20 A are repeatedly stacked, to reduce crystal defects by restricting the thickness of the GaN layer doped at a high concentration to below 100 A, and to prevent reduction of the entire doping concentration of the n-side contact layer 310 and maintain crystallinity by using the un-GaN layer with a thickness not greater than 100 A. In the meantime, PCT Publication No. WO/99/046822 suggests a technology of recovering low crystallinity of the n-side contact layer 410, by forming the n-side contact layer 410 with a thickness of 3 µm at a doping concentration of 3 × 10¹⁹/cm³, and forming thereon the n-type nitride semiconductor layer 420 having the superlattice structure or multilayered structure. However, although the fact that the strain which can be borne by the light emitting device is variable according to a used buffer layer or the like is taken into consideration, it will be quite difficult to manufacture a light emitting device including an n-type nitride semiconductor layer grown to a thickness of a few µm at a doping concentration of 5 × 10¹⁸/cm³, as a product for sale.

Accordingly, the conventional light emitting device nothing but suggests an n-side contact layer having a single film or superlattice structure with an entire doping concentration not greater than 5 × 10¹⁸/cm³ so as to increase the doping concentration of the n-side contact layer and maintain crystallinity.

Meanwhile, PCT Publication No. WO/06/009372 conceptually suggests a doping method of an n-type nitride semiconductor layer which repeatedly stacks a GaN layer doped at a concentration of 1 × 10²¹/cm³, and an un-InGaN layer with a thickness of 10 A to 200 A grown at a temperature of 800 °C to 950 °C. It does not mention anything about an n-side contact layer.

### [Disclosure]

### [Technical Problem]

Accordingly, the present invention has been made to solve the above-described shortcomings occurring in the prior art, and an object of the present invention is to provide a III-nitride semiconductor light emitting device which can solve the foregoing problems.

Another object of the present invention is to provide a III-nitride semiconductor light emitting device which includes an n-type nitride semiconductor layer with a high concentration and high crystallinity.

Yet another object of the present invention is to provide a III-nitride semiconductor light emitting device which can maintain crystallinity even in a high concentration doping such as 5 × 10¹⁹/cm³.

Yet another object of the present invention is to provide a III-nitride semiconductor light emitting device which includes an n-side contact layer formed by a new doping method.

Yet another object of the present invention is to provide a III-nitride semiconductor light emitting device which has a high doping concentration and high crystallinity by adjusting a thickness of an undoped n-type nitride semiconductor layer outside a range of a superlattice structure (over 100 A).

Yet another object of the present invention is to provide a III-nitride semiconductor light emitting device which improves ESD characteristic.

Yet another object of the present invention is to provide a III-nitride semiconductor light emitting device which introduces a nitride semiconductor layer over 100 A into an n-side contact layer to improve ESD characteristic.

Yet another object of the present invention is to provide a III-nitride semiconductor light emitting device which solves a current bottleneck phenomenon.

### [Technical Solution]

To this end, there is provided a III-nitride semiconductor light emitting device, including: an n-type nitride semiconductor layer having a structure where a first nitride semiconductor layer doped into n-type and a second nitride semiconductor layer with a lower doping concentration than that of the first nitride semiconductor layer and a thickness over 100 A are alternately stacked in a plural number; a p-type nitride semiconductor layer; an active layer positioned between the n-type nitride semiconductor layer and the p-type nitride semiconductor layer to generate light by recombination of electrons and holes; an n-side electrode electrically connected to the n-type nitride semiconductor layer; and a p-side electrode electrically connected to the p-type nitride semiconductor layer. Here, the first nitride semiconductor layer is doped at a high concentration, for example, of 5 × 10¹⁹/cm³, so that the n-type nitride semiconductor layer can have a doping concentration over 1 × 10¹⁹/cm³ as a whole. Preferably, the second nitride semiconductor layer is not doped, but can be unintendedly or intendedly doped. When the second nitride semiconductor layer is doped over 1 × 10¹⁸/cm³, it is not easy to expect the effect of the present invention.

In another aspect of the present invention, there is provided a III-nitride semiconductor light emitting device, including: an active layer for generating light by recombination of electrons and holes; a p-type nitride semiconductor layer positioned on one side of the active layer; an n-side contact layer positioned on the other side of the active layer, and including a first nitride semiconductor layer with a thickness over 100 A to improve crystallinity and facilitate current spreading; and an n-side electrode being in contact with the n-side contact layer. The present invention suggests a novel III-nitride semiconductor light emitting device by introducing a layer over 100 A into an n-side contact layer to improve crystallinity and facilitate current spreading, which has been considered as impossible. Further, the present invention improves ESD characteristic of the light emitting device in this configuration.

### [Advantageous Effects]

According to a III-nitride semiconductor light emitting device of the present invention, current spreading can be facilitated and ESD characteristic can be improved.

Also, according to a III-nitride semiconductor light emitting device of the present invention, an n-type nitride semiconductor layer, particularly, an n-side contact layer can be doped at a high concentration, while maintaining crystallinity.

Also, according to a III-nitride semiconductor light emitting device of the present invention, a new doping method of approximating an n-side surface resistance to a p-side surface resistance (about 10 to 20 Ω per unit area, particularly, about 15 Ω) can be employed, while maintaining crystallinity.

Also, a doping method, a crystallinity recovering method and/or an ESD characteristic improving method in accordance with the present invention can be applied to a vertical structure III-nitride semiconductor light emitting device without departing from the technical ideas of the present invention.

### [Description of Drawings]

FIG. 1 is a view illustrating one example of a conventional III-nitride semiconductor light emitting device.
FIG. 2 is an explanatory view illustrating a doping method of an n-type nitride semiconductor layer disclosed in US Patent 5,733,796.
FIG. 3 is an explanatory view illustrating a doping method of an n-type nitride semiconductor layer disclosed in PCT Publication No. WO/99/005728.

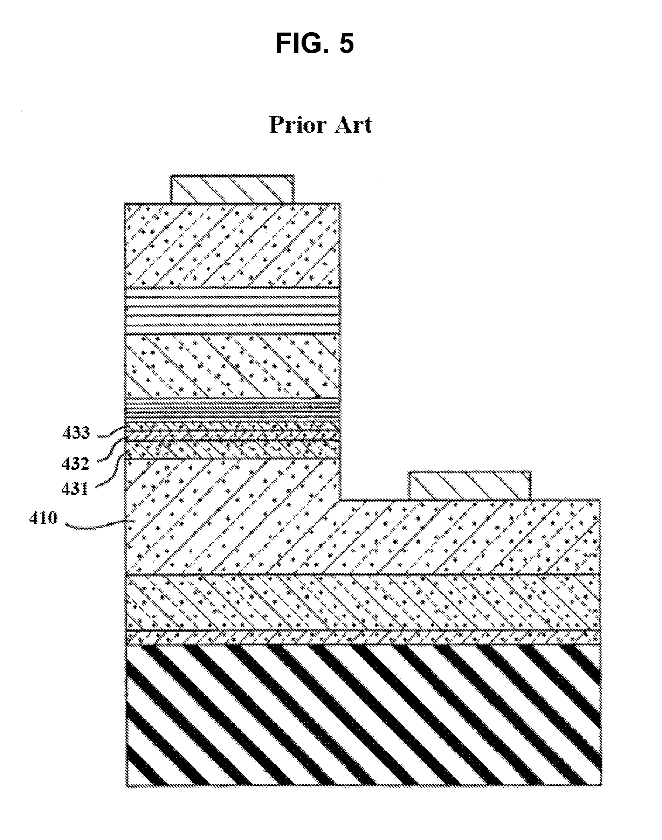

FIGS. 4 and 5 are explanatory views illustrating a doping method of an n-type nitride semiconductor layer disclosed in PCT Publication No. WO/99/046822.

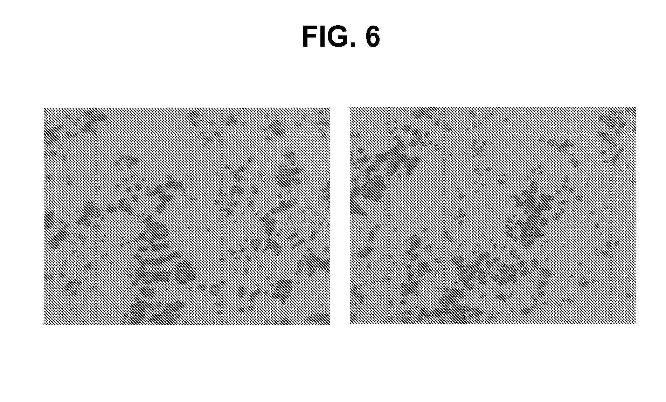

FIG. 6 is a view illustrating an experiment example according to the present invention.

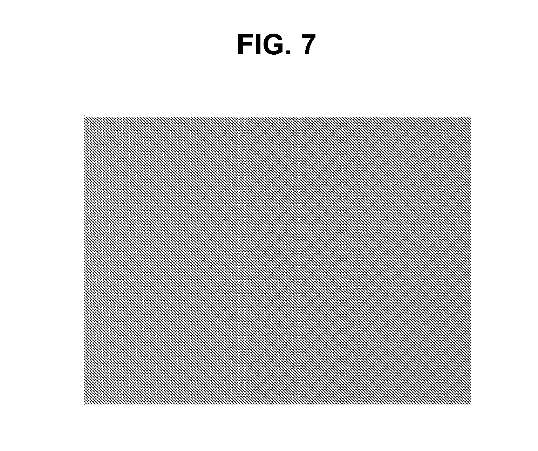

FIG. 7 is a view illustrating another experiment example according to the present invention.

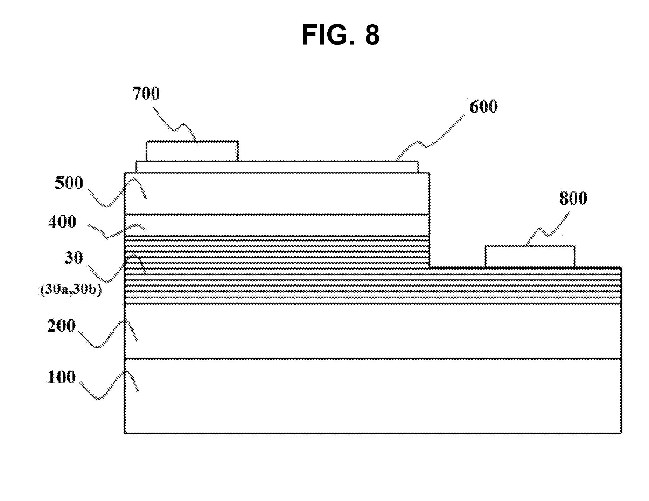

FIG. 8 is a view illustrating a III-nitride semiconductor light emitting device according to the present invention.

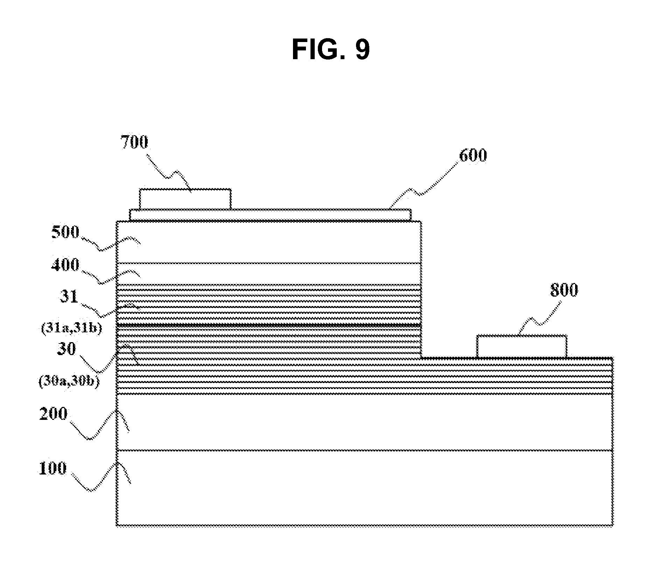

FIG. 9 is a view illustrating another III-nitride semiconductor light emitting device according to the present invention.

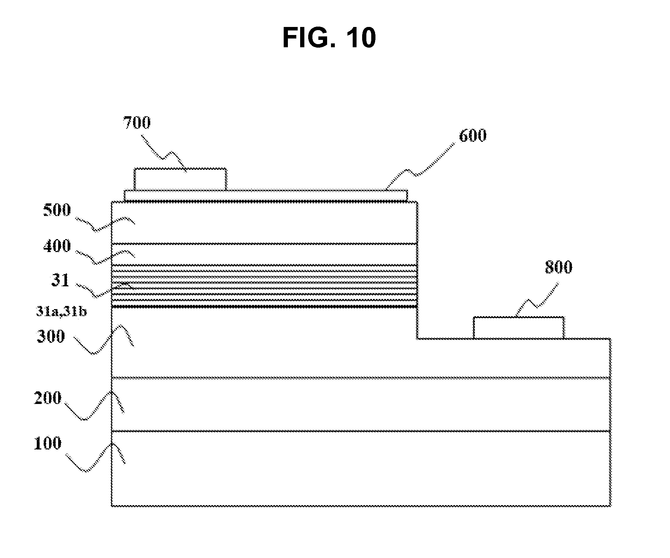

FIG. 10 is a view illustrating another III-nitride semiconductor light emitting device according to the present invention.

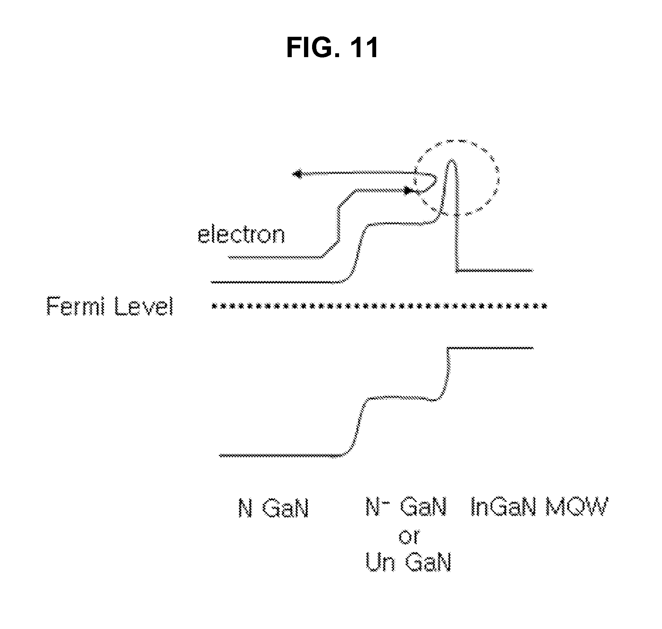

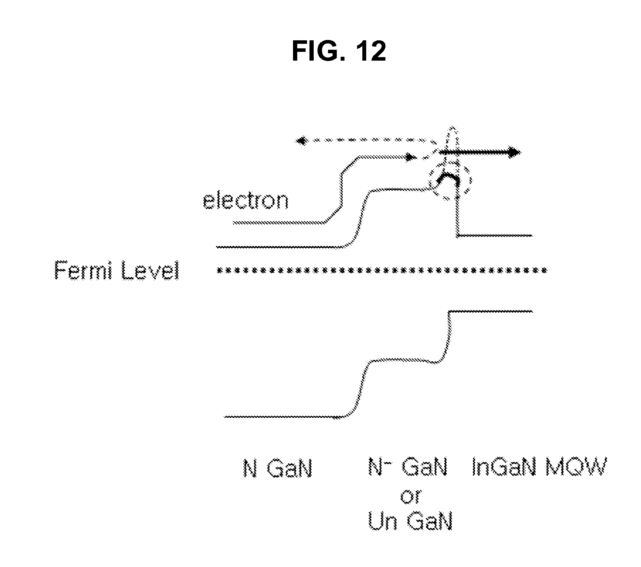

FIGS. 11 and 12 are explanatory views illustrating a principle of improving ESD characteristic.

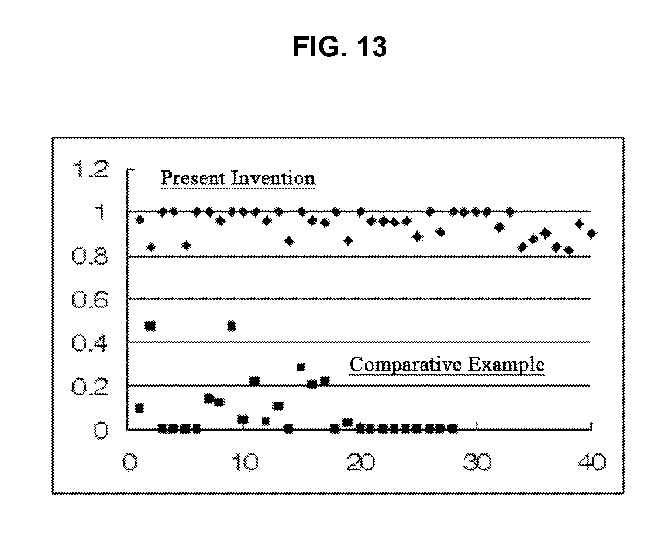

FIG. 13 is a view illustrating one example of an ESD characteristic measurement result according to the present invention.

### [Mode for Invention]

Hereinafter, the present invention will be described in detail with reference to the accompanying drawings.

FIG. 6 is a view illustrating an experiment example according to the present invention, particularly, a surface microscope photograph (left side) showing a state where an n-type nitride semiconductor layer with a thickness of about 2 µm was grown by repeatedly stacking an n-type GaN layer with a doping concentration of 5 × 10¹⁹/cm³ (supplying 9.5 sccm of DTBSi as Si source) and a thickness of 60 A and an un-GaN layer with a thickness of 100 A (by adjusting a supply time of Si source, e.g., supplying Si source for 15 seconds and stopping supply for 25 seconds), and a surface microscope photograph (right side) showing a state where an n-type nitride semiconductor layer was grown in a different condition by supplying 9.0 sccm of DTBSi as Si source. This experiment was to examine whether crystallinity could be improved by lowering a doping concentration of an n-type nitride semiconductor layer from a high concentration doping such as 5 × 10¹⁹/cm³. As known from both photographs, a lot of pits existed on the surfaces, and even though a doping concentration was lowered from in a high concentration doping such as 5 × 10¹⁹/cm³, while a thickness ratio being maintained, crystallinity had not improved much. Before forming this stacked structure, a buffer layer and an un-GaN layer with a thickness of 2 µm were grown on a sapphire substrate in advance. The buffer layer could be formed by means of the above-described methods. Here, an SiC/InGaN buffer layer was used as the buffer layer. That is, according to this experiment, in a case where crystallinity of an n-type GaN layer is extremely degraded due to a high doping concentration over 1 × 10¹⁹/cm³, even if an un-GaN layer not greater than 100 A existing within a superlattice structure range of the prior art is used as a recovery layer, entire crystallinity of an n-type nitride semiconductor layer cannot be ensured. Accordingly, although the prior art shown in FIG. 3 points out that an n-type GaN layer below 100 A and an un-GaN layer below 100 A can be used, as a matter of fact, an n-type GaN layer with a doping concentration of 1 × 10¹⁹/cm³ and a small thickness of 20 A is used, and a thin un-GaN layer of about 20 A is used to maintain an entire doping concentration of an n-side contact layer.

FIG. 7 is a view illustrating another experiment example according to the present invention, particularly, a surface microscope photograph showing a state where an n-type nitride semiconductor layer with a thickness of about 2 µm was grown by repeatedly stacking an n-type GaN layer with a doping concentration of 5 × 10¹⁹/cm³ (supplying 9.5 sccm of DTBSi as Si source) and a thickness of 60 A and an un-GaN layer with a thickness of 180 A. According to this experiment, although an n-type GaN layer has a high doping concentration over 1 × 10¹⁹/cm³, since an un-GaN layer has a thickness over a certain value, it is possible to form a high concentration n-type nitride semiconductor layer without degrading crystallinity. In addition, according to this experiment, although an un-GaN layer which is three times as thick as a doped n-type GaN layer (doping concentration of 5 × 10¹⁹/cm³) is stacked, an n-type nitride semiconductor layer not only has an entire doping concentration of about 1.25 × 10¹⁹/cm³ which is much higher than that of the prior art, but also maintains crystallinity.

In a case where an n-type GaN layer existing within a superlattice range is doped over 1 × 10¹⁹/cm³ (e.g., 5 × 10¹⁹/cm³), it is assumed that Si is not just doped on the GaN layer, but the GaN layer and the SiN layer coexist. When an un-GaN layer below a predetermined thickness is formed on the n-type GaN layer, it is thought that the un-GaN layer is not formed on the SiN layer, thereby generating a lot of pits. In the prior art, in a case where an n-type GaN layer is excessively doped, crystallinity thereof is seriously degraded. Therefore, the n-type GaN layer cannot be doped over a certain value. However, on the basis of the foregoing experiment, the present inventors found out that, even if an n-type GaN layer was extremely doped, when a recovery layer over a certain thickness was formed to solve the defect, crystallinity of the entire stacked structure could be ensured and a doping concentration of the whole layer could be maintained higher. Under this understanding, the present invention suggests a new doping method of an n-type nitride semiconductor layer, and introduces a nitride semiconductor layer over 100 A into an n-side contact layer to recover crystallinity and improve ESD characteristic.

FIG. 8 is a view illustrating a III-nitride semiconductor light emitting device according to the present invention. The III-nitride semiconductor light emitting device includes a substrate 100, a buffer layer 200 epitaxially grown on the substrate 100, an n-type nitride semiconductor layer 30 epitaxially grown on the buffer layer 200, an active layer 400 epitaxially grown on the n-type nitride semiconductor layer 30, a p-type nitride semiconductor layer 500 epitaxially grown on the active layer 400, a p-side electrode 600 formed on the p-type nitride semiconductor layer 500, a p-side bonding pad 700 formed on the p-side electrode 600, and an n-side electrode 800 formed on the n-type nitride semiconductor layer exposed by mesa-etching the p-type nitride semiconductor layer 500 and the active layer 400. The light emitting device of FIG. 8 is identical in configuration to the conventional light emitting device of FIG. 1 except a structure of an n-type nitride semiconductor layer 30. The n-type nitride semiconductor layer 30 is formed by alternately repeatedly stacking an n-type GaN layer 30a with a doping concentration over 1 × 10¹⁹/cm³ and an un-GaN layer 30b with a thickness over 100 A. Since the un-GaN layer 30b is introduced into an n-side contact layer through the n-type nitride semiconductor layer 30, ESD characteristic in the light emitting device can be improved, and an n-side surface resistance can be lowered to approximate to a p-side surface resistance (about 10 to 20 Ω per unit area), ensuring crystallinity.

There is no special limitation on the entire thickness of the n-type nitride semiconductor layer 30 as the n-side contact layer. In a case where the n-type nitride semiconductor layer 30 is mesa-etched to form the n-side electrode 800 thereon, it preferably has a thickness over 1 µm in consideration of an etching process and a deposition process and for sufficient spreading of supplied current to the whole light emitting device.

There is no special limitation on a thickness of the un-GaN layer 30b except that the un-GaN layer 30b has a thickness over 100 A to be distinguished from the general superlattice structure. For example, when the n-type GaN layer 30a is formed at a doping concentration of 5 × 10¹⁹/cm³ with a thickness of 60 A, the un-GaN layer 30b can be formed with a thickness of 180 A. Here, the un-GaN layer 30b must be sufficiently thick to overcome crystal defects generated on the n-type GaN layer 30a. If the un-GaN layer 30b is too thick, when the n-side electrode 800 is formed on the un-GaN layer 30b, an operation voltage may be excessively raised. Therefore, the thickness of the un-GaN layer 30b exists preferably between 100 A and 300 A, more preferably, between 150 A and 200 A. The thickness of the un-GaN layer 30b can be changed according to the thickness and doping concentration of the n-type GaN layer 30a and the entire doping concentration of the n-type nitride semiconductor layer 30.

Also, the doping concentration of the n-type GaN layer 30a needs to exceed 1 × 10¹⁹/cm³, so that the light emitting device can normally operate even though the n-side electrode 800 is formed on the un-GaN layer 30b, and the n-type nitride semiconductor layer 30 has a high concentration as a whole. The upper limit may be different according to manufacturers. If the n-type GaN layer 30a has excessive crystal defects, it cannot be easily recovered by the un-GaN layer 30b. Therefore, preferably, the doping concentration is not great than 1 × 10²¹/cm³. More preferably, the doping concentration ranges from 3 × 10¹⁹/cm³ to 6 × 10¹⁹/cm³ to decrease the thickness of the un-GaN layer 30b and to increase the entire doping concentration of the n-type nitride semiconductor layer 30. This value can be changed according to the thickness of the n-type GaN layer 30a and the entire doping concentration of the n-type nitride semiconductor layer 30.

The thickness of the n-type GaN layer 30a is preferably over 20 A so that the n-type GaN layer 30a can sufficiently contain Si. If the n-type GaN layer 30a is excessively thick, it is difficult to recover crystallinity. Accordingly, the thickness of the n-type GaN layer 30a is preferably not greater than 150 A, more preferably, not greater than 100 A. In consideration of both aspects, more preferably, the n-type GaN layer 30a has a thickness of 50 A to 80 A.

The stacking period number of the n-type GaN layer 30a and the un-GaN layer 30b is determined according to the entire layer thickness (generally, about 2 to 4 µm) of the n-type nitride semiconductor layer 30. When an n-type GaN layer 30a of 60 A and an un-GaN layer 30b of 180 A are formed at about 2 µm, 100 periods are required. According to the foregoing conditions of each layer of the present invention, ten or more un-GaN layers 30b are necessary to form a light emitting device according to the present invention.

With respect to the material composition of the n-type GaN layer 30a and the un-GaN layer 30b, an InGaN layer may be used instead of the un-GaN layer 30b. However, there are several problems in growing INGaN. For example, it is necessary to lower growth temperature. However, it can be considered to dope In on the un-GaN layer 30b.

Meanwhile, the un-GaN layer 30b can be doped unintendedly or intendedly. 'Unintended doping' means that Si can be introduced from the n-type GaN layer 30a, and 'Intended doping' means that Si can be doped to improve the entire doping concentration of the n-type nitride semiconductor layer 30 as far as the un-GaN layer 30b functions as a crystal recovering layer of the n-type GaN layer 30a and an ESD characteristic improving layer. A dopant needs not to be limited to Si.

In addition, the n-type GaN layer 30a and the un-GaN layer 30b do not essentially have the same doping concentration and thickness in the stacked structure.

Moreover, the stacked structure of the n-type nitride semiconductor layer 30 may start from the n-type GaN layer 30a or the un-GaN layer 30b, but preferably ends in the un-GaN layer 30b.

FIG. 9 is a view illustrating another III-nitride semiconductor light emitting device according to the present invention. The III-nitride semiconductor light emitting device includes a substrate 100, a buffer layer 200 epitaxially grown on the substrate 100, an n-type nitride semiconductor layer 30 epitaxially grown on the buffer layer 200, an active layer 400 epitaxially grown on the n-type nitride semiconductor layer 30, a p-type nitride semiconductor layer 500 epitaxially grown on the active layer 400, a p-side electrode 600 formed on the p-type nitride semiconductor layer 500, a p-side bonding pad 700 formed on the p-side electrode 600, and an n-side electrode 800 formed on the n-type nitride semiconductor layer exposed by mesa-etching the p-type nitride semiconductor layer 500 and the active layer 400. As different from the light emitting device of FIG. 8, the light emitting device of FIG. 9 includes a second n-type nitride semiconductor layer 31 between the n-type nitride semiconductor layer 30 and the active layer 400. The second n-type nitride semiconductor layer 31 serves to spread current to the entire light emitting device and improve ESD characteristic. In addition, the second n-type nitride semiconductor layer 31 serves to protect the active layer 400 from the nitride semiconductor layer 30 doped at a high concentration (e.g., 1.25 × 10¹⁹/cm³).

The second n-type nitride semiconductor layer 31 has a repeated stacked structure of an n-type GaN layer 31 a and an un-GaN layer 31 b. The n-type GaN layer 31 a can be formed to be identical to or similar to an n-type GaN layer 30a. The un-GaN layer 31 b is formed as thick as possible to spread current, recover crystals and improve ESD characteristic. Since the un-GaN layer 31 b does not have any limitation due to formation of the n-side electrode 800, it can be formed thick. However, if the un-GaN layer 31 b is excessively thick, a resistance increases to raise an operation voltage. Therefore, the un-GaN layer 31 b preferably has a thickness of 300 A to 2000 A, more preferably, 800 A to 1500 A. On the contrary, if the un-GaN layer 31 b is excessively thin, it cannot have a function of spreading current and protecting the active layer 400. For example, the second n-type nitride semiconductor layer 31 can be formed at a thickness of 0.4 µm by repeatedly stacking an n-type GaN layer 31 a with a doping concentration of 4 × 10¹⁹/cm³ and a thickness of 60 A and an un-GaN layer 31 b with a thickness of 1200 A.

FIG. 10 is a view illustrating another III-nitride semiconductor light emitting device according to the present invention. The III-nitride semiconductor light emitting device includes a substrate 100, a buffer layer 200 epitaxially grown on the substrate 100, an n-type nitride semiconductor layer 300 epitaxially grown on the buffer layer 200, an active layer 400 epitaxially grown on the n-type nitride semiconductor layer 300, a p-type nitride semiconductor layer 500 epitaxially grown on the active layer 400, a p-side electrode 600 formed on the p-type nitride semiconductor layer 500, a p-side bonding pad 700 formed on the p-side electrode 600, and an n-side electrode 800 formed on the n-type nitride semiconductor layer exposed by mesa-etching the p-type nitride semiconductor layer 500 and the active layer 400. As different from the light emitting device of FIG. 9, the light emitting device of FIG. 10 includes a second n-type nitride semiconductor layer 31 between the n-type nitride semiconductor layer 300 and the active layer 400, and includes a general n-type nitride semiconductor layer 300 which is a single film, instead of the n-type nitride semiconductor layer 30.

In order to improve ESD characteristic, a conventional light emitting device can include a thick un-GaN layer or an n-GaN layer doped at a low concentration between an n-type nitride semiconductor layer 300 and an active layer 400. However, as illustrated in FIG. 11, supply efficiency of electrons supplied to the active layer is reduced due to a potential barrier (indicated by a dotted circle) caused by hetero-junction of the active layer and the un-GaN layer or the n-GaN layer with a low doping concentration.

According to the present invention, when the n-type GaN layer 31 a doped at a high concentration and the thick un-GaN layer 31 b are repeatedly stacked, the entire second n-type nitride semiconductor layer 31 has high crystallinity and a high concentration. As shown in a dotted circle of FIG. 12, a potential barrier is lowered to prevent rise of an operation voltage. In addition, the un-GaN layer 31 b serves to spread current, thereby improving ESD characteristic.

FIG. 13 is a view illustrating one example of an ESD characteristic measurement result according to the present invention. 34 devices were sampled in a wafer, 1 kV (Human body model, Noiseken series) was applied thereto in a backward direction, and leakage parameters Vr and Ir were measured before and after the application, to judge an electrostatic characteristic. For a comparative example, an InGaN/SiC buffer layer was formed on a sapphire substrate, 2 µm of un-GaN layer was formed thereon, an n-type GaN layer with a doping concentration of 5 × 10¹⁸/cm³ and a thickness of 2 µm as an n-side contact layer, an n--GaN layer with a doping concentration of 1 × 10¹⁷/cm³ and a thickness of 0.4 µm, and an n-GaN layer with a doping concentration of 2 × 10¹⁸/cm³ and a thickness of 0.02 µm were formed, and an active layer of MQW structure and a p-type GaN layer were formed thereon. According to the present invention, 2 µm of n-side contact layer was formed by alternately stacking an n-type GaN layer with a doping concentration of 5 x 10¹⁸/cm³ and a thickness of 60 A and an un-GaN layer with a thickness of 180 A, and 0.4 µm of second n-type nitride semiconductor layer was formed by alternately stacking an n-type GaN layer with a doping concentration of 4 × 10¹⁹/cm³ and a thickness of 60 A and an un-GaN layer with a thickness of 1200 A. Here, a growth speed of the GaN layer was about 6 A/s, and DTBSi was supplied for 10 seconds at 9.5 sccm and stopped for 30 seconds to form the n-side contact layer, and supplied for 10 seconds and stopped for 200 seconds to form the second n-type nitride semiconductor layer. A growth temperature was 1050 °C, H₂ was used as a carrier gas, TMGa was used as Ga source, and NH₃ was used as N source.

As known from this experiment, although the comparative example includes the n-GaN layer on the n--GaN layer, it shows a yield below 40 %. On the contrary, the present invention shows an excellent effect, i.e., a yield over 80 %.

## Claims

1. A III-nitride semiconductor light emitting device, comprising:
an n-type nitride semiconductor layer (30) having a structure where a first nitride semiconductor layer (30a) doped into n-type and a second nitride semiconductor layer (30b) with a lower doping concentration than that of the first nitride semiconductor layer (30a) and a thickness over 100 A are alternately stacked in a plural number;
a p-type nitride semiconductor layer (500);
an active layer (400) positioned between the n-type nitride semiconductor layer (30) and the p-type nitride semiconductor layer (500) to generate light by recombination of electrons and holes;
an n-side electrode (800) electrically connected to the n-type nitride semiconductor layer (30); and
a p-side electrode (600) electrically connected to the p-type nitride semiconductor layer (500).

2. The III-nitride semiconductor light emitting device of Claim 1,
wherein the n-side electrode (800) is formed on a mesa-etched region of the n-type nitride semiconductor layer (30).

3. The III-nitride semiconductor light emitting device of Claim 1,
wherein the first nitride semiconductor layer (30a) is formed of GaN.

4. The III-nitride semiconductor light emitting device of Claim 1,
wherein the second nitride semiconductor layer (30b) is formed of GaN.

5. The III-nitride semiconductor light emitting device of Claim 1,
wherein the second nitride semiconductor layer (30b) is formed of undoped GaN.

6. The III-nitride semiconductor light emitting device of Claim 1,
wherein the first nitride semiconductor layer (30a) is doped at a doping concentration over 1 × 10¹⁹/cm³.

7. The III-nitride semiconductor light emitting device of Claim 1,
wherein the n-type nitride semiconductor layer (30) has a doping concentration over 1 × 10¹⁹/cm³ as a whole.

8. The III-nitride semiconductor light emitting device of Claim 1, further comprising a second n-type nitride semiconductor layer (31) positioned between the n-type nitride semiconductor layer (30) and the active layer (400),
wherein the second n-type nitride semiconductor layer (31) has a structure where a third nitride semiconductor layer (31 a) doped into n-type, and a fourth nitride semiconductor layer (31 b) with a lower doping concentration than that of the third nitride semiconductor layer (31 a) and a larger thickness than that of the second nitride semiconductor layer (30b) are alternately stacked in a plural number.

9. The III-nitride semiconductor light emitting device of Claim 8,
wherein the fourth nitride semiconductor layer (31 b) is formed of GaN.

10. The III-nitride semiconductor light emitting device of Claim 9,
wherein the fourth nitride semiconductor layer (31 b) has a thickness of 300 A to 2000 A.

11. A III-nitride semiconductor light emitting device, comprising:
an n-side contact layer (30) having a structure where a first n-type GaN layer (30a) doped into n-type and a first un-GaN layer (30b) with a thickness over 100 A are alternately stacked in a plural number;
a p-type nitride semiconductor layer (500);
an active layer (400) positioned between the n-side contact layer (30) and the p-type nitride semiconductor layer (500) to generate light by recombination of electrons and holes;
an n-side electrode (800) electrically connected to the n-side contact layer (30); and
a p-side electrode (600) electrically connected to the p-type nitride semiconductor layer (500).

12. The III-nitride semiconductor light emitting device of Claim 11,
wherein the first n-type GaN layer (30a) has a thickness below 100 A and a doping concentration over 1 × 10¹⁹/cm³.

13. The III-nitride semiconductor light emitting device of Claim 11,
wherein the first n-type GaN layer (30a) has a thickness of 50 A to 80 A and a doping concentration of 3 × 10¹⁹/cm³ to 6 × 10¹⁹/cm³.

14. The III-nitride semiconductor light emitting device of Claim 11,
wherein the n-side contact layer (30) comprises ten or more first un-GaN layers (30b).

15. The III-nitride semiconductor light emitting device of Claim 11, further comprising an n-type nitride semiconductor layer (31) positioned between the n-side contact layer (30) and the active layer (400),
wherein the n-type nitride semiconductor layer (31) has a structure where a second n-type GaN layer (31 a) doped into n-type at a lower doping concentration than the first n-type GaN layer (30a) and a second un-GaN layer (31 b) with a larger thickness than that of the first un-GaN layer (30b) are alternately stacked in a plural number.
